# FASCICULE DE BREVET EUROPEEN

(11) **EP 1 469 981 B1**
(45) Date de publication et mention de la délivrance du brevet: **18.03.2009**
(21) Numéro de dépôt: 03712201.7
(22) Date de dépôt: 02.01.2003
(51) Int. Cl.: B28D 5/00

(54) **DISPOSITIF DE COUPE DE COUCHE D'UN SUBSTRAT ET PROCÉDÉ ASSOCIÉ**
VORRICHTUNG ZUM SCHNEIDEN EINER SUBSTRATSCHICHT UND ENTSPRECHENDES VERFAHREN
DEVICE FOR CUTTING A SUBSTRATE LAYER, AND CORRESPONDING METHOD

(30) Priorité: 03.01.2002 FR 0200028
(43) Date de publication de la demande: 27.10.2004
(73) Titulaire: S.O.I.Tec Silicon on Insulator Technologies, 38190 Bernin (FR)
(72) Inventeur: RAYSSAC, Olivier, F-38100 Grenoble (FR); LETERTRE, Fabrice, F-38000 Grenoble (FR)
(74) Mandataire: Le Forestier, Eric
(86) Numéro de dépôt international: PCT/FR2003/000002
(87) Numéro de publication internationale: WO 2003/059591

(56) Documents cités:
- EP-A- 0 925 888
- US-B1- 6 221 740

## Description

La présente invention concerne de manière générale le traitement des matériaux, et plus particulièrement de substrats pour l'électronique, l'optique ou l'optroélectronique.

Plus précisément, l'invention concerne un dispositif de coupe automatique de haute précision d'une couche de matériau qui est solidaire d'un substrat source par l'intermédiaire d'une zone fragilisée, le substrat source et la couche à couper formant un ensemble à couper, le dispositif comprenant des moyens de coupe ainsi que des moyens de maintien de l'ensemble à couper.

On précise que par « coupe » on entend dans ce texte l'opération consistant à diviser en deux parties disjointes un même élément ou ensemble, et à garantir que lesdites parties ne se réunissent pas à nouveau.

Comme on va le voir, une telle coupe est dans le cadre de l'invention réalisée au niveau d'une zone fragilisée.

Et l'invention concerne également un procédé de coupe automatique de haute précision d'une couche de matériau qui est solidaire d'un substrat source par l'intermédiaire d'une zone fragilisée, le substrat source et la ' couche à couper formant un ensemble à couper, le procédé comprenant :
- le positionnement de l'ensemble à couper par des moyens de maintien,
- la coupe de la couche par des moyens de coupe.

On précise que l'invention est particulièrement adaptée à la coupe de couches dont l'épaisseur est inférieure à une centaine de microns, et en particulier à la coupe de couches dites « minces », dont l'épaisseur est de l'ordre du micron.

Des dispositifs et procédés tels qu'évoqués ci-dessus sont utilisés pour constituer des couches (minces ou non), qui peuvent être destinées à être transférées du substrat source auquel elles ont été prélevées vers un support dit « support cible ».

Les substrats se présentent généralement sous la forme de disques appelés « wafers » selon la terminologie anglo-saxonne répandue. Les wafers peuvent être réalisés dans un matériau semi-conducteur tel que le silicium.

Il est connu de constituer à l'intérieur d'un wafer une zone fragilisée selon un plan parallèle aux faces principales du wafer.

La zone fragilisée peut être réalisée par implantation d'ions bombardés sur la surface du wafer, ces ions créant dans le volume du wafer une couche fragilisée délimitant une région inférieure (qui correspond dans le cadre de ce texte au substrat source) et une région supérieure adjacente à la source d'ions (qui correspond dans le cadre de ce texte à la couche qui sera coupée).

On trouvera dans le document FR 2 681 472 un exemple d'un tel procédé, qui permet de réaliser des couches minces.

Il est également possible de réaliser la zone fragilisée par tout autre moyen connu en soi, par exemple en construisant une région intermédiaire de matériau poreux entre deux régions de matériau dense, en constituant une couche d'oxyde enterrée dans un substrat (par exemple un substrat de type SOI (Silicon On Insulator selon la terminologie anglo-saxonne répandue), ou encore en effectuant un collage de deux couches, la zone de collage correspondant à la zone fragilisée.

On précise qu'il est également possible de traiter de la sorte des substrats de type SOA (Silicon On Anything selon la terminologie anglo-saxonne répandue) ou même de type AOA (Anything On Anything selon la terminologie anglo-saxonne répandue). La coupe de tels substrats entre ainsi dans le cadre de l'invention.

Pour réaliser la coupe au niveau de la zone fragilisée et constituer avec le substrat source et la couche à couper deux éléments disjoints, il est possible de faire appel à un opérateur manuel.

Mais le recours à un opérateur manuel constitue un facteur limitant pour la cadence de production des couches.

De plus, dans ce cas la reproductibilité des opérations n'est pas garantie.

On connaît également des dispositifs et procédés de coupe automatique, qui visent à s'affranchir des inconvénients précités.

Un exemple d'un tel dispositif et procédé est divulgué dans le document EP 925 888.

Le dispositif de ce document utilise l'impact d'un jet d'eau sur la tranche d'un wafer qui est par ailleurs maintenu sur ses deux faces principales, pour attaquer une zone fragilisée et diviser le wafer en deux parties.

Ce dispositif comprend ainsi des moyens de maintien associés aux deux faces respectives du wafer, lesdits moyens de maintien autorisant un certain écartement, prédéterminé, des deux parties du wafer lors de la coupe.

Il est en effet important de gérer finement l'écartement des deux parties du wafer qui sont situées de part et d'autre de la zone fragilisée, en particulier lorsque ces deux parties sont réalisées dans des matériaux différents.

Par exemple, dans le cas de la coupe d'un ensemble à couper comprenant une couche de silicium solidaire d'un substrat de SiC par l'intermédiaire d'une zone fragilisée, la couche de silicium subit une déformation importante (le substrat de SiC étant beaucoup plus rigide et se déformant beaucoup moins), ce qui peut conduire à la détérioration de cette couche de silicium.

Et le dispositif du document EP 925 888 tente ainsi d'apporter une solution pour accompagner de manière désirée l'écartement et/ou la déformation des deux parties du wafer que l'on désire couper.

Toutefois, une limitation liée à ce dispositif est qu'il ne comprend que des moyens passifs, pour autoriser un certain écartement et/ou une certaine déformation.

Ces moyens passifs correspondent à des configurations particulières des moyens de maintien, dont la surface peut comprendre des cavités de géométries données afin d'autoriser un certain écartement des parties du wafer.

Il est également possible, selon ce document, de donner à la surface desdits moyens de maintien une forme généralement convexe ou encore de prévoir, à la surface de ces moyens de maintien qui est en contact avec le wafer, une couche de matériau élastique.

Mais en tout état de cause, de telles solutions passives ne permettent que l'accompagnement de l'écartement et/ou de la déformation des parties du wafer, cet écartement/déformation étant « subi » ; aucun réel contrôle (c'est à dire un contrôle selon un mode actif) n'est assuré par le dispositif du document EP 925 888.

On remarquera en outre que les moyens de maintien doivent également mettre le wafer en rotation pour que la totalité de la périphérie de celui-ci soit attaquée par le jet-d'eau, ce qui-complexifie la conception et le fonctionnement du dispositif.

Un but de l'invention est de s'affranchir des inconvénients mentionnés ci-dessus en permettant de réaliser la coupe de couches, en particulier de couches minces, en contrôlant l'écartement et/ou la déformation des parties de l'ensemble à couper.

Un autre but de l'invention est de permettre de réaliser les opérations de coupe de manière entièrement automatisée.

Afin d'atteindre ces buts, l'invention propose selon un premier aspect un dispositif de coupe automatique de haute précision d'une couche de matériau qui est solidaire d'un substrat source par l'intermédiaire d'une zone fragilisée, le substrat source et la couche à couper formant un ensemble à couper, le dispositif comprenant des moyens de coupe ainsi que des moyens de maintien de l'ensemble à couper, caractérisé en ce que les moyens de maintien sont aptes à être déplacés de manière contrôlée afin d'accompagner de manière active l'écartement et/ou la déformation des parties de l'ensemble à couper, et de corriger cet écartement et/ou cette déformation.

Des aspects préférés, mais non limitatifs du dispositif selon l'invention sont les suivants :
- les moyens de coupe comprennent une lame pour attaquer l'ensemble à couper,
- les moyens de coupe comprennent un moyen pour générer un jet de fluide pressurisé,
- les moyens de maintien sont également aptes à être déplacé de manière contrôlée pour induire dans l'ensemble à couper des contraintes, en vue de faciliter la coupe,
- les moyens de maintien comprennent un préhenseur associé à chaque partie respective de l'ensemble à couper,
- le déplacement contrôlé des moyens de maintien peut s'effectuer perpendiculairement au plan de coupe,
- le déplacement contrôlé des moyens de maintien peut s'effectuer parallèlement au plan de coupe,
- le dispositif comprend un moyen de capteur apte à acquérir une donnée représentative de la progression des opérations de coupe,
- le dispositif comprend en outre une boucle de régulation permettant d'asservir le déplacement contrôlé des moyens de maintien aux observations dudit moyen de capteur.
- ledit moyen de capteur comprend des diodes électroluminescentes disposées de part et d'autre dans l'ensemble à couper, permettant de caractériser la progression de l'écartement des parties de l'ensemble à couper,
- le dispositif comprend deux lames,
- chaque lame du dispositif à un bord d'attaque ayant un profil en croissant de lune, de manière à attaquer la périphérie de l'ensemble à couper sur une grande partie.

Selon un deuxième aspect, l'invention propose également un procédé de coupe automatique de haute précision d'une couche de matériau qui est solidaire d'un substrat source par l'intermédiaire d'une zone fragilisée, le substrat source et la couche à couper formant un ensemble à couper, le procédé comprenant :
- le positionnement de l'ensemble à couper par rapport à des moyens de maintien,
- la coupe de la couche par des moyens de coupe,
caractérisé en ce que le procédé comprend le contrôle du déplacement des moyens de maintien de manière à accompagner de manière active l'écartement et/ou la déformation des parties de l'ensemble à couper.

Des aspects préférés, mais non limitatifs du procédé selon l'invention sont les suivants :
- le déplacement contrôlé des moyens de maintien est réalisé en conjonction avec l'attaque de l'ensemble à couper par les moyens de coupe,
- l'acquisition d'au moins une donnée représentative de l'évolution de la coupe, et on asservit le déplacement contrôlé des moyens de maintien à cette observation,
- le contrôle du déplacement des moyens de maintien permet un contrôle du déplacement desdits moyens dans le plan de coupe de l'ensemble à couper,
- le contrôle du déplacement des moyens de maintien permet un contrôle du déplacement desdits moyens dans la direction perpendiculaire au plan de coupe de l'ensemble à couper.

D'autres aspects, buts et avantages de l'invention apparaîtront mieux à la lecture suivante d'une forme de réalisation de l'invention, faite à titre d'exemple non limitatif en référence aux dessins annexés sur lesquels :
- la figure 1 est une vue schématique en élévation latérale du dispositif de coupe selon l'invention.
- la figure 2 est une vue schématique de dessus du même dispositif.

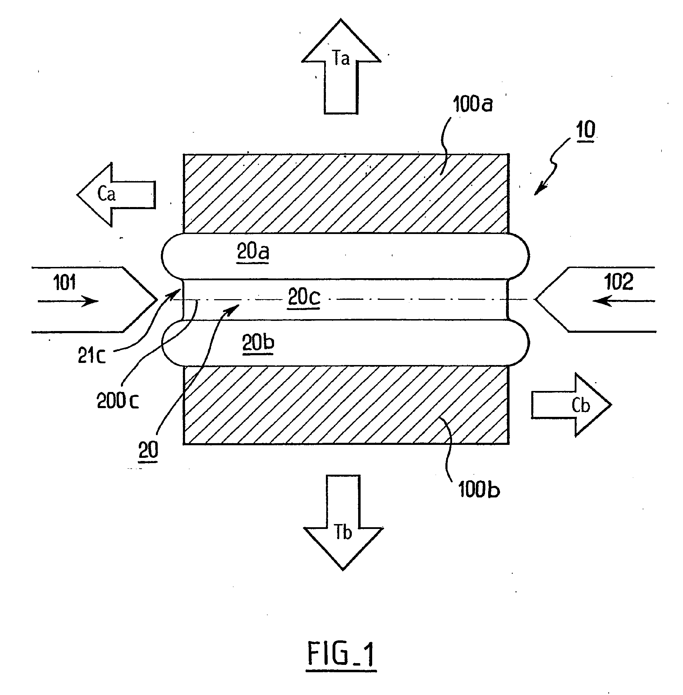

En référence à la figure 1 on a représenté de manière schématique un dispositif de coupe désigné par la référence générale 10, et un wafer 20 qui constitue un ensemble à couper.

On précise que si sur les représentations très schématiques des figures, le wafer 20 est représenté avec une épaisseur apparemment importante, dans la réalité ce wafer peut avoir une épaisseur extrêmement réduite.

Typiquement, le wafer peut ainsi avoir un épaisseur de quelques millimètres; pour un diamètre qui peut être de l'ordre de 20 à 30 centimètres (ces valeurs n'étant nullement limitatives).

Le wafer 20 est constitué de deux parties 20a et 20b ayant une forme générale de disque, séparées par une région intermédiaire 20c qui comprend une zone de fragilisation 200c.

La zone de fragilisation 200c s'étend de manière générale selon un plan parallèle aux faces principales du wafer.

Cette zone de fragilisation peut, comme cela a été dit en introduction de ce texte, avoir été réalisée par implantation mais également par toute autre méthode connue en soi.

On précise que les deux parties 20a et 20b peuvent être réalisées dans le même matériau (en particulier dans le cas de la réalisation de la zone 200c par implantation), ou dans des matériaux différents.

Par convention, on nommera « substrat source », la partie inférieure 20b du wafer, et « couche à couper », la partie supérieure 20a.

Comme représentés sur la figure 1, les bords des deux parties 20a et 20b peuvent être arrondis ou chanfreinés comme cela est l'usage en particulier pour les couches de matériau semi-conducteur. Dans ce cas, les deux parties 20a et 20b définissent un chanfrein annulaire 21c au niveau de la région intermédiaire 20c.

Il est cependant également possible que les bords des parties 20a et 20b aient toute géométrie donnée.

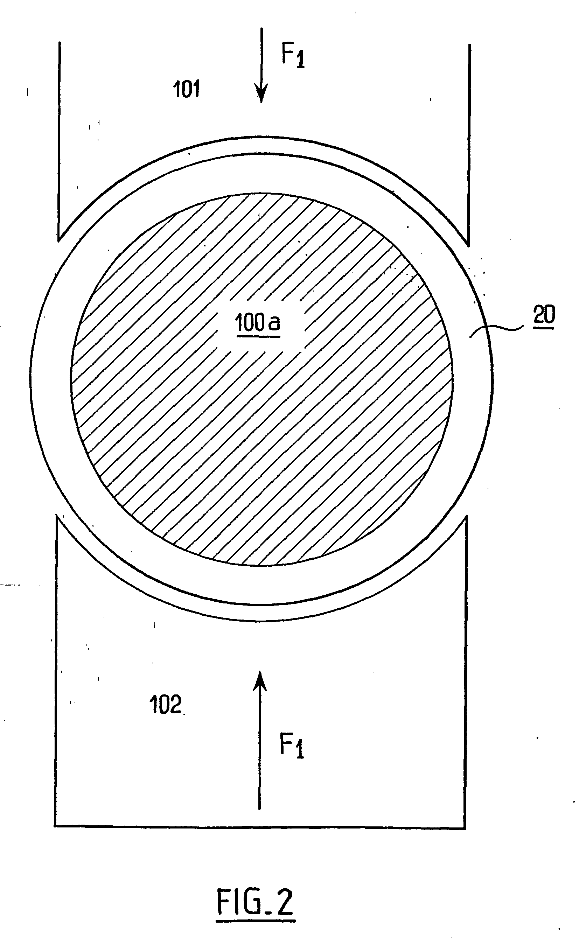

Le dispositif 10 comprend quant à lui les éléments suivants :
- au moins une lame pour attaquer le wafer 20 au niveau de sa zone fragilisée 200c.
   Dans l'exemple particulier représenté sur les figures 1 et 2, le dispositif 10 comprend deux lames 101 et 102 disposées dans le plan de la zone fragilisée 200c (que l'on nommera « plan de coupe»), et diamétralement opposées de part et d'autre du wafer de manière à l'attaquer sur deux côtés opposés de sa périphérie.
   Toutefois, il est également possible de réaliser le dispositif 10 avec une seule des deux lames 101 et 102, l'autre lame pouvant dans ce cas être simplement supprimée, ou encore remplacée par un cale fixe contribuant à maintenir la position du wafer lors de la coupe (cette fonction de maintien étant comme on va le voir assurée par ailleurs),
- et des moyens de maintien du wafer pendant les opérations de coupe. Dans le cadre de l'invention, ces moyens de maintien sont réalisés sous la forme de deux préhenseurs 100a et 100b, en prise avec les faces externes des parties respectives 20a et 20b, qui constituent les deux faces externes du wafer.

Les préhenseurs 100a et 100b comprennent chacun des moyens de préhension de la face du wafer à laquelle ils sont associés.

Ces moyens de préhension peuvent par exemple comprendre des ventouses, et/ou des cavités de la surface du préhenseur qui est destinée à être en contact avec le wafer, lesdites cavités pouvant être mises en dépression pour solidariser le préhenseur et sa partie de wafer associée.

Ces moyens de préhension peuvent par ailleurs être réalisés sous toute forme connue, permettant d'assurer la fonction de préhension de la partie de wafer en assurant entre le préhenseur et sa partie de wafer associée une cohésion suffisamment importante pour maintenir de manière rigide la position relative du préhenseur et de sa partie de wafer associée, pendant la totalité de l'opération de coupe (y compris pendant l'attaque de la lame qui va être détaillée ci-dessous).

Chacun des deux préhenseurs 100a et 100b est par ailleurs monté sur des moyens de déplacement respectifs, aptes à déplacer leur préhenseur associé dans le plan de coupe, et dans la direction dite « verticale » (perpendiculaire à ce plan de coupe).

Ces moyens de déplacement des préhenseurs ne sont pas représentés sur les figures par souci de simplification et de clarté.

On précise que ces moyens de déplacement sont ainsi aptes à commander le déplacement contrôlé de chaque préhenseur indépendamment de l'autre préhenseur.

Des moyens de commande sont également associés à chaque lame du dispositif pour commander le déplacement de la lame dans le plan de coupe, de l'extérieur du wafer vers son centre.

On précise que si les lames ont été représentées avec une épaisseur apparente importante, de même que cela a été dit à propos du wafer lui-même ci-dessus, l'épaisseur de la lame est en réalité très réduite (de l'ordre du millimètre), le rôle de la lame étant d'attaquer la périphérie du wafer au niveau de la zone fragilisée sans toutefois pour autant pénétrer nécessairement jusqu'au centre du wafer.

Comme représenté sur la figure 2, les lames peuvent avoir en vue de dessus un contour de bord d'attaque en « quartier de lune » dont la concavité correspond à la courbure de la périphérie de wafer, de manière à attaquer cette périphérie sur une partie importante.

Il est également possible de prévoir qu'une lame principale attaque le wafer pour amorcer la coupe en générant un front de décollement qui se propage entre les deux parties 20a et 20b, puis de faire prendre le relais de cette attaque par deux autres lames, placées symétriquement de part et d'autre du wafer par rapport à la direction d'attaque de la première lame.

En tout état de cause, quels que soient le nombre de lames du dispositif et leur cinématique de déplacement, le déplacement des préhenseurs est également contrôlé, en conjonction avec l'attaque du wafer par la ou les lame(s).

C'est en effet la combinaison spécifique des moyens évoqués ci-dessus (lame(s), et préhenseurs) qui permet de réaliser la coupe du wafer dans les meilleures conditions.

Plus précisément, c'est la combinaison de l'action de chaque lame du dispositif, et des préhenseurs qui agissent sur les deux faces externes du wafer, qui permet de réaliser cette coupe de manière efficace.

Plus précisément encore, on commande le déplacement de chaque lame pour que la lame attaque le wafer au niveau de sa zone fragilisée 200c, et ce en conjonction avec une commande du déplacement de chaque préhenseur selon une cinématique prédéterminée, les cinématiques de déplacement des deux préhenseurs pouvant être différentes tout en étant synchronisées entre elles.

Les préhenseurs assurent ainsi les fonctions suivantes, en conjonction de l'attaque du wafer par la (les) lame(s) du dispositif :
- premièrement, les préhenseurs assurent le maintien de leur partie de wafer associée, dans le plan de coupe, de sorte que la position du wafer est contrôlée dans ce plan lors de l'attaque de la lame ou des lames du dispositif.
   Ce contrôle de la position des parties du wafer peut par exemple être réalisé en immobilisant les parties du wafer pendant une phase particulière de la coupe (en particulier pendant l'attaque initiale du wafer par la lame).
   Les préhenseurs constituent ainsi des moyens de maintien du wafer, qui permettent aux lames d'attaquer ledit wafer dans les meilleurs conditions,
- deuxièmement, les préhenseurs sont déplacés de manière contrôlée dans le plan de coupe, et/ou dans la direction verticale :
   ➢ Le déplacement contrôlé des parties du wafer selon la direction verticale a pour premier effet d'accompagner de manière contrôlée et active la déformation en écartement des parties du wafer, ladite déformation résultant de l'attaque de(s) lame(s) et de la propagation d'un front de décollement entre ces parties.
      Il est possible d'observer la propagation d'un tel front de décollement, et d'asservir le déplacement des préhenseurs en écartement selon la direction verticale à la progression observée du front de décollement, grâce à une boucle de régulation adaptée.
      On précise toutefois que dans l'optique d'un dispositif entièrement automatisé et présentant de grandes qualités de fiabilité et de robustesse, une solution préférée consiste à asservir le déplacement des préhenseurs (en écartement, mais également dans le plan de coupe comme cela va être évoqué plus loin dans ce texte) non pas à l'observation de la propagation d'un front décollement, mais à l'observation de l'écartement entre les deux parties du wafer.
      Et on trouvera plus loin dans ce texte une description de moyens simples permettant de caractériser de manière efficace un tel écartement. Dans ce cas, la boucle de régulation qui permet de commander le déplacement de chaque préhenseur est asservie aux observations d'écartement issues de tels moyens.
      Ainsi, on assure un contrôle actif de l'écartement et/ou de la déformation des parties du wafer que l'on coupe. Cette disposition est avantageuse, notamment par rapport aux moyens enseignés par le document EP 925 888 qui sont purement passifs et subissent la déformation des parties du wafer sans influer de manière active sur elle.
   ➢ Plus précisément, ce déplacement contrôlé des parties du wafer selon la direction verticale peut être défini de manière à corriger la déformation et/ou l'écartement des parties du wafer lors de la coupe, si la déformation et/ou l'écartement observés (par une caméra adaptée à cet effet, ou par exemple par tout système optique - voir à cet égard le développement spécifique ci-dessous) ne correspondent pas à des conditions désirées (valeurs observées pour la déformation et/ou l'écartement trop fortes, trop faibles, ou n'évoluant pas de manière désirée).
      Une telle correction peut résulter du déplacement de chaque partie de wafer 20a, 20b indépendamment de l'autre partie, ces déplacements n'étant pas nécessairement symétriques (en particulier dans le cas où les deux parties sont réalisées dans des matériaux différents, ayant des caractéristiques mécaniques différentes).
      Ainsi, en fonction des caractéristiques du wafer (en particulier en fonction de la nature des matériaux qui constituent les deux parties du wafer), on pourra garder un des préhenseurs immobiles, tandis qu'on commande le déplacement contrôlé de l'autre préhenseur uniquement.
      On précise que si le moyen essentiel de contrôle résulte du déplacement contrôlé de chaque préhenseur, on pourra en outre donner à la surface des préhenseurs qui est en contact avec la face de wafer associée toute forme désirée et adaptée pour favoriser un type de déformation (forme convexe, surface de préhenseur présentant des cavités ou des canaux, ...).
      ➢ Et au-delà du contrôle de déformation et/ou écartement des parties du wafer, les déplacements des préhenseurs dans la direction verticale peuvent en outre être commandés non seulement pour accompagner de manière contrôlée un tel écartement et/ou une telle déformation, mais également en outre pour induire dans le wafer des contraintes de traction (selon les flèches Ta et Tb), de manière à favoriser encore la coupe.
   ➢ On rappelle à cet égard que les moyens de préhension associés à chaque préhenseur garantissent une liaison rigide entre chaque préhenseur et sa partie de wafer associée, de sorte que chaque préhenseur est à solliciter en traction ladite partie de wafer.
   ➢ Enfin, il est également possible, en combinaison avec les dispositions ci-dessus, de commander un déplacement contrôlé des préhenseurs dans le plan de coupe, par exemple en déplaçant les préhenseurs selon des trajectoires opposées et éventuellement alternatives, pour induire entre les deux parties du wafer des contraintes de cisaillement. Ceci a pour effet de favoriser encore la coupe. Cet effet de cisaillement est représenté sur la figure 1, qui représente des contraintes opposées Ca et Cb appliquées aux deux parties respectives du wafer, parallèlement au plan de coupe mais dans des sens opposés.

On rappelle que la force de cohésion entre chaque préhenseur et sa partie de wafer associée est suffisamment importante pour que le préhenseur reste totalement solidaire de sa partie de wafer associée lors de ses différents déplacements.

Ainsi, l'invention offre une combinaison tout à fait originale de :
- moyens de coupe, et
- moyens de maintien aptes à être déplacés de manière contrôlée.

Ceci permet de combiner les avantages de l'attaque d'un ensemble à couper par une lame, qui joue le rôle d'un « coin » introduit entre les deux parties du wafer, et favorise ainsi la génération d'un front de décollement, à l'action des préhenseurs qui induisent des contraintes dans le wafer.

On précise que la ou les lame(s) du dispositif peuvent être remplacées par un autre type de moyen de coupe, dont on combinera toujours l'action à celle des moyens de maintien que sont les préhenseurs.

Les moyens de coupe peuvent ainsi être des moyens permettant de générer un jet de fluide pressurisé, qui est dirigé sur la zone fragilisée du wafer.

Et il est également possible de prévoir que le moyen de coupe que l'on associe aux préhenseurs combine au moins une lame et des moyens permettant de générer un tel jet de fluide pressurisé. Il est ainsi possible de prévoir qu'au moins une lame du dispositif comprend un canal interne d'alimentation en fluide pressurisé, ledit canal débouchant au niveau de la pointe du bord d'attaque de la lame pour permettre la projection du fluide sur la zone fragilisée du wafer en combinaison avec l'attaque de la lame.

L'ensemble des dispositions évoquées ci-dessus à propos du contrôle de la position et du déplacement des préhenseurs - et donc des parties de wafer associées - sera mis en oeuvre de préférence en combinaison avec un système de suivi de la déformation et/ou de l'écartement des parties du wafer.

Plus précisément, afin de favoriser au maximum une automatisation fiable et robuste du dispositif, une solution avantageuse est de retenir des moyens de visualisation directe de l'écartement des parties du wafer.

On pourra ainsi disposer dans le plan de coupe, de part et d'autre du wafer par rapport à la direction générale d'attaque de la ou des lame(s) du dispositif (donc par rapport à la direction générale de propagation du front de décollement), des séries de diodes électroluminescentes s'étendant selon cette direction générale d'attaque des lames (direction des flèches F1 sur la figure2).

Les diodes sont disposées par paires de part et d'autre de la direction générale d'attaque de la ou des lame(s) du dispositif, chaque diode d'une paire étant en regard de l'autre.

Une diode de chaque paire émet ainsi un faisceau lumineux vers l'autre diode, qui reçoit ce faisceau en l'absence d'obstacle entre les deux diodes.

De cette manière, dès que les parties du wafer - normalement interposées entre les deux diodes de chaque paire - sont suffisamment écartées (du fait de la coupe), le faisceau émis par la diode émettrice est reçu par la diode réceptrice.

En disposant ainsi selon la direction générale d'attaque de la ou des lame(s) du dispositif les paires de diodes, et en reliant chaque diode réceptrice à une centrale de suivi équipée d'un processeur, on peut suivre la progression de l'écartement des parties du wafer et contrôler en conséquence le déplacement des préhenseurs.

On précise qu'il est possible d'adapter les cinématiques respectives régissant l'action :
- d'une part les moyens de coupe,
- et d'autre part des préhenseurs,
afin d'adapter au mieux l'apport de contraintes mécaniques entre les deux parties du wafer, en fonction des caractéristiques de celui-ci (nature des matériaux constituant les deux parties du wafer etc...).

D'une manière générale, il est ainsi important que les déplacements contrôlés des préhenseurs soient réalisés en conjonction avec l'attaque du wafer par les moyens de coupe. Par « en conjonction », on désigne de manière générale le fait de combiner l'action de ces deux types de moyen.

On pourra commander tout d'abord l'attaque de la zone fragilisée du wafer par les moyens de coupe (lame(s) ou autre), les préhenseurs entrant ensuite en action pour exploiter l'écartement initial provoqué entre les ,parties du wafer par l'effet de « coin » des moyens de coupe.

Mais il est également possible de solliciter tout-d'abord les deux parties du wafer en écartement, en appliquant des tractions opposées des préhenseurs sur ces deux parties respectives, avant de faire entrer en action les moyens de coupe.

## Revendications

1. Dispositif de coupe automatique de haute précision d'une couche de matériau (20a) qui est solidaire d'un substrat source (20b) par l'intermédiaire d'une zone fragilisée (200 c), le substrat source et la couche à couper formant un ensemble à couper (20), le dispositif comprenant des moyens de coupe (101, 102) ainsi que des moyens de maintien (100a, 100b) de l'ensemble à couper, **caractérisé en ce que** les moyens de maintien sont aptes à être déplacés de manière contrôlée afin d'accompagner de manière active l'écartement et/ou la déformation des parties de l'ensemble à couper, et de corriger cet écartement et/ou cette déformation.

2. Dispositif selon la revendication précédente **caractérisé en ce que** les moyens de coupe comprennent une lame pour attaquer l'ensemble à couper.

3. Dispositif selon la revendication 1 ou 2, **caractérisé en ce que** les moyens de coupe comprennent un moyen pour générer un jet de fluide pressurisé.

4. Dispositif selon l'une des revendications précédentes **caractérisé en ce que** les moyens de maintien sont également aptes à être déplacés de manière contrôlée pour induire dans l'ensemble à couper des contraintes, en vue de faciliter la coupe.

5. Dispositif selon l'une des revendications précédentes, **caractérisé en ce que** les moyens de maintien comprennent un préhenseur associé à chaque partie respective de l'ensemble à couper.

6. Dispositif selon l'une des revendications précédentes, **caractérisé en ce que** le déplacement contrôlé des moyens de maintien peut s'effectuer perpendiculairement au plan de coupe.

7. Dispositif selon l'une des revendications précédentes, **caractérisé en ce que** le déplacement contrôlé des moyens de maintien peut s'effectuer parallèlement au plan de coupe.

8. Dispositif selon l'une des revendications précédentes, **caractérisé en ce que** le dispositif comprend un moyen de capteur apte à acquérir une donnée représentative de la progression des opérations de coupe.

9. Dispositif selon la revendication précédente, **caractérisé en ce que** le dispositif comprend en outre une boucle de régulation permettant d'asservir le déplacement contrôlé des moyens de maintien aux observations dudit moyen de capteur.

10. Dispositif selon l'une des deux revendications précédentes, **caractérisé en ce que** ledit moyen de capteur comprend des diodes électroluminescentes disposées de part et d'autre de l'ensemble à couper, permettant de caractériser la progression de l'écartement des parties de l'ensemble à couper.

11. Dispositif selon l'une des revendications précédentes, **caractérisé en ce que** le dispositif comprend deux lames.

12. Dispositif selon l'une des revendications précédentes, **caractérisé en ce que** chaque lame du dispositif a un bord d'attaque ayant un profil en croissant de lune, de manière à attaquer la périphérie de l'ensemble à couper sur une partie importante de celle-ci.

13. Procédé de coupe automatique de haute précision d'une couche de matériau qui est solidaire d'un substrat source par l'intermédiaire d'une zone fragilisée, le substrat source et la couche à couper formant un ensemble à couper, le procédé comprenant :
• le positionnement de l'ensemble à couper par des moyens de maintien,
• la coupe de la couche par des moyens de coupe,
**caractérisé en ce que** le procédé comprend le contrôle du déplacement des moyens de maintien afin d'accompagner de manière active l'écartement et/ou la déformation des parties de l'ensemble à couper.

14. Procédé selon la revendication précédente, **caractérisé en ce que** ledit déplacement contrôlé des moyens de maintien est réalisé en conjonction avec l'attaque de l'ensemble à couper par les moyens de coupe.

15. Procédé selon l'une des deux revendications précédentes, **caractérisé en ce que** on procède en outre à l'acquisition d'au moins une donnée représentative de l'évolution de la coupe, et on asservit le déplacement contrôlé des moyens de maintien à cette observation.

16. Procédé selon l'une des trois revendications précédentes, **caractérisé en ce que** le contrôle du déplacement des moyens de maintien permet un contrôle du déplacement desdits moyens dans le plan de coupe de l'ensemble à couper.

17. Procédé selon l'une des quatre revendications précédentes, **caractérisé en ce que** le contrôle du déplacement des moyens de maintien permet un contrôle du déplacement desdits moyens dans la direction perpendiculaire au plan de coupe de l'ensemble à couper.

## Claims

1. High-precision automatic cutting device of a layer of material (20a) which is attached to a source substrate (20b) via an embrittled zone (200 c), the source substrate and the layer to be cut forming an assembly to be cut (20), the device comprising cutting means (101, 102) and holding means (100a, 100b) of the assembly to be cut, **characterised in that** the holding means are capable of being moved in a controlled manner in order to actively accompany the spacing apart and/or deformation of each part of the assembly to be cut, and correct said spacing apart and/or deformation.

2. Device according to the above claim **characterised in that** the cutting means comprise a blade to engage the assembly to be cut.

3. Device according to claim 1 or 2,
**characterised in that** cutting means comprise means to generate a pressurised fluid jet.

4. Device according to any of the above claims **characterised in that** the holding means are also capable of being moved in a controlled manner to induce strains in the assembly to be cut, with a view to facilitating cutting.

5. Device according to any of the above claims **characterised in that** the holding means comprise a gripper associated with each respective part of the assembly to be cut.

6. Device according to any of the above claims **characterised in that** the controlled movement of the holding means may be performed perpendicular to the cutting plane.

7. Device according to any of the above claims **characterised in that** the controlled movement of the holding means may be performed parallel with the cutting plane.

8. Device according to any of the above claims **characterised in that** the device comprises a sensor means capable of acquiring a representative data item of the progression of the cutting operations.

9. Device according to any of the above claims **characterised in that** the device comprises a control loop used to control the controlled movement of the holding means with the observations of said sensor means.

10. Device according to any of the above claims **characterised in that** said sensor means comprises light-emitting diodes arranged at either side of the assembly to be cut used to characterise the progression of the spacing apart of the parts of the assembly to be cut.

11. Device according to any of the above claims **characterised in that** the device comprises two blades.

12. Device according to any of the above claims **characterised in that** each blade of the device has a leading edge with a crescent-shaped profile, so as to engage essentially the periphery of the assembly.

13. High-precision automatic cutting method of a layer of material which is attached to a source substrate via an embrittled zone, the source substrate and the layer to be cut forming an assembly to be cut, the method comprising:
- positioning of the assembly to be cut with reference to holding means,
- cutting of the layer by cutting means,
**characterised in that** the method comprises the control of the movement of the holding means so as to actively accompany the spacing apart and/or the deformation of the parts of the assembly to be cut.

14. Method according to the above claim, **characterised in that** said controlled movement of the holding means is performed in conjunction with the engagement of the assembly to be cut by the cutting means.

15. Method according to any of the above two claims, **characterised in that** the acquisition of at least one representative data item of the progression of cutting is also carried out and the controlled movement of the holding means is controlled with this observation.

16. Method according to any of the above three claims, **characterised in that** the control of the movement of the holding means enables control of the movement of said means in the cutting plane of the assembly to be cut.

17. Method according to any of the above four claims, **characterised in that** the control of the movement of the holding means enables control of the movement of said means in the direction perpendicular to the cutting plane of the assembly to be cut.

## Patentansprüche

1. Vorrichtung zum hochgenauen automatischen Abschneiden einer Materialschicht (20a), die mit einem Ausgangssubstrat (20b) mittels einer versprödeten Zone (200 c) verbunden ist, wobei das Ausgangssubstrat und die abzuschneidende Schicht eine zu schneidende Gesamtheit (20) bilden, und die Vorrichtung Mittel zum Schneiden (101, 102) und Mittel zum Halten (100a, 100b) der zu schneidenden Gesamtheit umfasst, **dadurch gekennzeichnet, dass** die Haltemittel derart gesteuert verlagerbar ausgebildet sind, dass sie dem Abstand und/oder der Verformung der Teile der zu schneidenden Gesamtheit aktiv nachfolgen und sie diesen Abstand und/oder diese Verformung korrigieren können.

2. Vorrichtung nach dem vorstehenden Anspruch, **dadurch gekennzeichnet, dass** die Schneidmittel eine Klinge umfassen, um die zu schneidende Gesamtheit anzugreifen.

3. Vorrichtung nach einem der Ansprüche 1 oder 2, **dadurch gekennzeichnet, dass** die Schneidmittel Mittel umfassen, um einen fluidischen Druckstrahl zu erzeugen.

4. Vorrichtung nach einem der vorstehenden Ansprüche, **dadurch gekennzeichnet, dass** die Haltemittel zusätzlich zu einer derartigen gesteuerten Verlagerung ausgebildet sind, dass mit ihnen in der zu schneidenden Gesamtheit eine Spannung zur Vereinfachung des Schnittes induzierbar ist.

5. Vorrichtung nach einem der vorstehenden Ansprüche, **dadurch gekennzeichnet, dass** die Haltemittel einen Greifer umfassen, der dem jeweils entsprechenden Teil der zu schneidenden Gesamtheit zugeordnet ist.

6. Vorrichtung nach einem der vorstehenden Ansprüche, **gekennzeichnet durch** eine gesteuerte Verlagerbarkeit der Haltemittel senkrecht zur Schnittebene.

7. Vorrichtung nach einem der vorstehenden Ansprüche, **gekennzeichnet durch** eine gesteuerte Verlagerbarkeit der Haltemittel parallel zur Schnittebene.

8. Vorrichtung nach einem der vorstehenden Ansprüche, **dadurch gekennzeichnet, dass** die Vorrichtung ein Sensormittel umfasst, das derart ausgebildet ist, dass es eine repräsentative Angabe über den Fortschritt von Schneidarbeiten erfasst.

9. Vorrichtung nach dem vorstehenden Anspruch, **dadurch gekennzeichnet, dass** die Vorrichtung außerdem einen Regelkreis umfasst, mit dessen Hilfe die Verlagerung der Haltemittel auf der Basis der Überwachung durch das Sensormittel steuerbar ist.

10. Vorrichtung nach einem der zwei vorstehenden Ansprüche, **dadurch gekennzeichnet, dass** das Sensormittel Leuchtdioden umfasst, die auf beiden Seiten der zu schneidenden Gesamtheit angeordnet sind, und es erlauben, das Fortschreiten des Abstands der Teile der zu schneidenden Gesamtheit zu kennzeichnen.

11. Vorrichtung nach einem der vorstehenden Ansprüche, **dadurch gekennzeichnet, dass** die Vorrichtung zwei Klingen umfasst.

12. Vorrichtung nach einem der vorstehenden Ansprüche, **dadurch gekennzeichnet, dass** jede Klinge der Vorrichtung eine Angriffskante aufweist, die ein mondsichelförmiges Profil aufweist, so dass der Umfang der zu schneidenden Gesamtheit auf einem erheblichen Teil desselben angegriffen wird.

13. Verfahren zum hochgenauen automatischen Abschneiden einer Materialschicht, die mit einem Ausgangssubstrat über eine versprödete Zone verbunden ist, wobei das Ausgangssubstrat und die abzuschneidende Schicht eine zu schneidende Gesamtheit bilden, wobei das Verfahren umfasst:
das Positionieren der zu schneidenden Gesamtheit durch Haltemittel,
das Abschneiden der Schicht durch Schneidmittel,
**dadurch gekennzeichnet, dass** die Haltemittel derart gesteuert verlagert werden, dass sie dem Abstand und/oder der Verformung von Teilen der zu schneidenden Gesamtheit aktiv nachfolgen.

14. Verfahren nach dem vorstehenden Anspruch, **dadurch gekennzeichnet, dass** die gesteuerte Verlagerung der Haltemittel in Verbindung mit dem Angriff der Schneidmittel auf die zu schneidende Gesamtheit verwirklicht ist.

15. Verfahren nach einem der zwei vorstehenden Ansprüche, **dadurch gekennzeichnet, dass** außerdem mindestens eine repräsentative Angabe über die Entwicklung des Schnitts erfasst und die gesteuerte Verlagerung der Haltemittel auf der Basis dieser Erfassung geregelt wird.

16. Verfahren nach einem der drei vorstehenden Ansprüche, **dadurch gekennzeichnet, dass** die Steuerung der Verlagerung der Haltemittel eine gesteuerte Verlagerung der Haltemittel in der Schnittebene der zu schneidenden Gesamtheit erlaubt.

17. Verfahren nach einem der vier vorstehenden Ansprüche, **dadurch gekennzeichnet, dass** die Steuerung der Verlagerung der Haltemittel eine gesteuerte Verlagerung der Haltemittel in der Richtung senkrecht zu der Schnittebene der zu schneidenden Gesamtheit erlaubt.
